# EUROPEAN PATENT SPECIFICATION

(11) **EP 2 696 381 B1**
(45) Date of publication and mention of the grant of the patent: **01.02.2017**
(21) Application number: 13003904.3
(22) Date of filing: 05.08.2013
(51) Int. Cl.: H01L 39/24

(54) **Niobium-titanium based superconducting wire**
Auf Niob-Titan basierter supraleitender Draht
Câble supraconducteur à base de niobium-titane

(30) Priority: 08.08.2012 JP 2012175928
(43) Date of publication of application: 12.02.2014
(73) Proprietor: Kabushiki Kaisha Kobe Seiko Sho (Kobe Steel, Ltd.), Kobe-shi, Hyogo 651-8585 (JP)
(72) Inventor: Zaitsu, Kyoji, Hyogo 651-2271 (JP)
(74) Representative: Müller-Boré & Partner Patentanwälte PartG mbB

(56) References cited:
- US-A- 5 116 429
- US-A- 5 226 947

## Description

The present invention relates to a niobium-titanium (Nb-Ti) based superconducting wire which exhibits high critical current density (Jc) and which is useful as a material for superconducting magnets used in medical analysis systems such as magnetic resonance imaging (MRI) systems and nuclear magnetic resonance (NMR) systems, power generation and storage systems such as nuclear fusion experimental reactors and superconducting magnetic energy storage (SMES) systems, and various characterization systems.

Superconducting magnets that generate a strong magnetic field by supplying a large current to a coil prepared by winding a superconducting wire are used in the above systems. Among metal-based superconducting wires practically used as materials for superconducting magnets, an Nb-Ti based superconducting wire is used in medical MRI systems in a large amount.

Among characteristics necessary for superconducting wires, a critical current characteristic (critical current density) is known as the most fundamental characteristic. The superconducting wires cannot unlimitedly conduct a large current. The critical current of each superconducting wire varies depending on conditions such as temperature and a magnetic field where the superconducting wire is placed.

An Nb-Ti based superconducting wire, which is usually prepared in such a way that an Nb-Ti alloy and a stabilizer are hybridized and drawn in such a state that the Nb-Ti alloy is placed in the stabilizer (usually oxygen-free copper), takes advantage of the fact that an Nb-Ti alloy becomes superconducting when the Nb-Ti alloy wire is cryogenically cooled. Increasing the current that can be conducted through the Nb-Ti alloy wire is important in improving characteristics of the Nb-Ti based superconducting wire.

Factors determining the critical current of the Nb-Ti based superconducting wire are probably the internal structure of the Nb-Ti alloy and the shape of an Nb-Ti alloy core (filament) in a final product (after wire drawing). In particular, the internal structure of the Nb-Ti alloy is probably a dominant factor determining the critical current thereof. As for the control of an internal structure, the homogenization of a structure has been mainly investigated. Variations in characteristics of the final product are reduced in such a way that the structure of an Nb-Ti alloy core in the Nb-Ti based superconducting wire, which is mass-produced, is homogenized. In particular, when characteristics of the final product are significantly varied, quenching (the sudden disruption of superconductivity) occurs during the energization of a superconducting magnet and therefore an expected magnetic field-generating function cannot be exhibited. However, such a control technique of an internal structure is directed to homogenize a structure and there is a limitation in increasing the critical current only by such an investigation.

A technique for improving characteristics of an Nb-Ti based superconducting wire has been proposed as disclosed in Japanese Unexamined Patent Application Publication No. 6-668725 This technique prevents a copper-titanium (Cu-Ti) intermetallic compound from being produced between an Nb-Ti alloy and a Cu-series metal (stabilizer) to suppress the reduction of the critical current. However, this technique does not improve characteristics of superconducting wires.

Further examples of prior art may be found in United States Patent Publications US5226947 and US5116429.

The present invention has been made under the foregoing circumstances. It is an object of the present invention to provide a method for manufacturing an Nb-Ti based superconducting wire capable of achieving a high critical current.

An Nb-Ti based superconducting wire, according to the present invention, capable of achieving the above object is manufactured in such a way that a stabilizer and an Nb-Ti alloy bar are hybridized and are then subjected to reduction working (extrusion or drawing). The Nb-Ti alloy bar has a grain size of 200 µm or less in terms of average equivalent circle diameter at the stage of hybridizing the Nb-Ti alloy bar with the stabilizer. The term "average equivalent circle diameter" as used herein refers to the average diameter (equivalent circle diameter) of circles equal in area to grains of an Nb-Ti alloy.

In the Nb-Ti based superconducting wire manufactured according to the present invention, the stabilizer is preferably copper. The Nb-Ti alloy bar subjected to reduction working preferably contains 16% by area or more of an α-phase in terms of proportion to the whole structure.

According to the present invention, the grain size of the Nb-Ti alloy bar is appropriately adjusted at the stage of hybridizing the Nb-Ti alloy bar with the stabilizer. Therefore, the production of the α-phase in an Nb-Ti alloy is promoted at the stage of reduction working and the Nb-Ti based superconducting wire can exhibit high critical current. The Nb-Ti based superconducting wire is extremely useful as a material for superconducting magnets used in MRI systems, NMR systems, and the like.
Fig. 1 is a schematic view illustrating the fundamental cross-sectional structure of an Nb-Ti based superconducting wire (round-shaped wire);
Fig. 2 is a traced drawing of a grain structure image obtained in Example 1;
Fig. 3 is a traced drawing of a grain structure image obtained in Example 2;
Fig. 4 is a traced drawing of a grain structure image obtained in Example 3; and
Fig. 5 is a traced drawing of a grain structure image obtained in Comparative Example 1.

The inventor has performed various investigations in order to improve the critical current of Nb-Ti based superconducting wires. As a result, the inventor has found that an Nb-Ti based superconducting wire exhibiting a high critical current is obtained in such a way that the grain size of an Nb-Ti alloy bar is controlled to be 200 µm or less in terms of average equivalent circle diameter at the stage of hybridizing the Nb-Ti alloy bar with a stabilizer, thereby completing the present invention. The principle of improving superconducting characteristics by the use of a configuration according to the present invention can be considered as described below.

The internal structure of an Nb-Ti alloy contained in the Nb-Ti based superconducting wire is a two-phase structure consisting of an α-phase (Ti phase) and β-phase (Nb-Ti phase) formed by heat treatment (usually annealing or aging at about 350°C to 450°C) performed during reduction working (extrusion or drawing). In the case where the Nb-Ti based superconducting wire is formed into a coil and the coil is cooled and is then energized in a superconducting state, the Nb-Ti alloy is exposed to a magnetic field generated in the coil.

At this time, the magnetic flux generated by the coil is quantized and is introduced into an Nb-Ti superconducting phase. When magnetic flux is present in a superconducting phase, Lorentz force is generated in the magnetic flux by the interaction with an applied current and therefore the magnetic flux moves. When the movement of the magnetic flux occurs, the critical current tends to decrease.

Measures to inhibit the movement of the magnetic flux include the idea of exhibiting "pinning". In the internal structure of the Nb-Ti based superconducting wire, the α-phase is a normal conducting phase and the β-phase is a superconducting phase. When the α-phase is present in the β-phase, the movement of the magnetic flux can be suppressed as if the magnetic flux is pinned, because the magnetic flux is energetically stable when the magnetic flux is located in the α-phase. This is referred to as "pinning". In order to inhibit the movement of the magnetic flux by "pinning", the amount (area fraction) of the α-phase needs to be as large as possible.

The α-phase is precipitated from the β-phase by heat treatment performed several times during the reduction working of the Nb-Ti based superconducting wire as described above. The precipitation of the α-phase mainly occurs predominantly on grain boundaries in the crystal structure of the β-phase. The inventor has noted this phenomenon and has further performed investigations by experiments, thereby revealing that when an Nb-Ti alloy base material (an Nb-Ti alloy at the stage of hybridization with the stabilizer) has a grain size of 200 µm or less in terms of average equivalent circle diameter, the area fraction of the α-phase can be increased after reduction working and the critical current of the Nb-Ti based superconducting wire can be increased. The grain size thereof is preferably 100 µm or less and more preferably 50 µm or less in terms of average equivalent circle diameter.

In order to control the grain size of the Nb-Ti alloy base material to be 200 µm or less in terms of average equivalent circle diameter, reduction working is performed at 70% or more at a temperature of 400°C or lower after casting and annealing may be performed at a temperature of 700°C or higher. One or a combination of extrusion, forging, and rolling can be chosen as a processing method used in this step.

An Nb-Ti based superconducting wire 3 according to the present invention exhibits its effect (a critical current-increasing effect) by precipitating an α-phase as much as possible after reduction working. From this viewpoint, the area fraction of the α-phase after reduction working is preferably at least 16% or more, more preferably 18% or more, and further more preferably 20% or more.

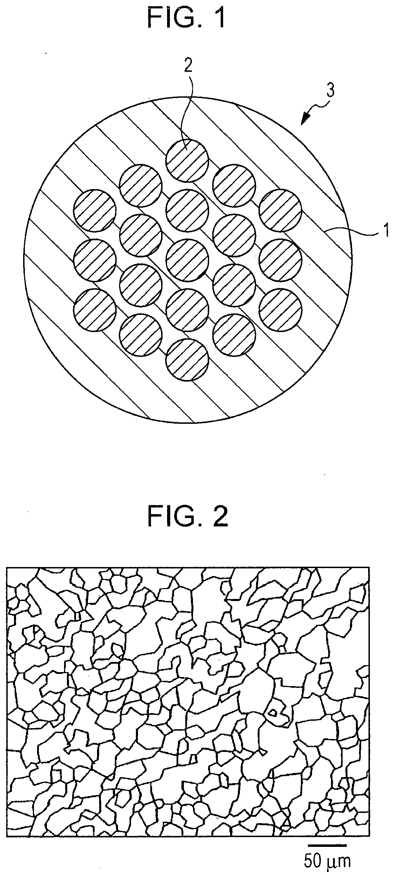

Fig. 1 is a schematic view illustrating the fundamental cross-sectional structure of the Nb-Ti based superconducting wire 3 (round-shaped wire). With reference to Fig. 1, the Nb-Ti based superconducting wire 3 includes a Cu matrix 1 and a plurality of Nb-Ti alloy filaments 2 (prepared from an Nb-Ti alloy bar by reduction working) which are arranged in the Cu matrix 1 so as not to contact each other. In Fig. 1, the number of the Nb-Ti alloy filaments 2 is 19 for convenience of illustration. In actual, the number of the Nb-Ti alloy filaments 2 is usually tens to hundreds.

The Nb-Ti based superconducting wire 3 is manufactured basically by a procedure below. The Nb-Ti alloy bar is inserted in a Cu pipe, which is then subjected to reduction working such as extrusion or drawing, whereby a single-core wire (usually having a hexagonal shape in cross section) including a Cu base material and an Nb-Ti alloy filament embedded therein is prepared. The single-core wire is cut into pieces having an appropriate length. The pieces are bundled or combined and are then inserted in a Cu pipe, whereby a pipe-shaped composite wire (multi-core wire) is prepared. Upon the preparation of the composite wire, Cu wires (Cu spacers) are placed in predetermined locations (peripheral portions, a central portion, and portions between Nb-Ti alloy filaments) in a cross section of the composite wire, the Cu wires being prepared by drawing Cu bars including no Nb-Ti alloy filament so as to have the same cross-sectional shape as that of the single-core wire, whereby regions containing no Nb-Ti alloy filament are controlled. The Cu pipes (the Cu pipes used to prepare the single-core wire and the multi-core wire) and the Cu spacers form the Cu matrix 1 as shown in Fig. 1. Layers (diffusion barrier layers) for preventing diffusion may be formed around the Nb-Ti alloy filaments 2 (that is, between Cu and the Nb-Ti alloy filaments 2) using Nb, Ta, or the like (Nb sheets described in an example below).

In the above configuration, the case of using Cu (usually oxygen-free copper) as a stabilizer is illustrated. A Cu alloy containing Cu and about 0.5% or less aluminum oxide (Al₂O₃) or the like may be used as a stabilizer. Alternatively, Al may be used as a stabilizer. In consideration of workability or a critical current, Cu (pure Cu) is preferably used. The Nb-Ti based superconducting wire 3 is circular in cross section as shown in Fig. 1 and may be a rectangular one (rectangular wire).

The composite wire is subjected to reduction working, whereby the Nb-Ti based superconducting wire 3 is obtained. Heat treatment for precipitating α-Ti is performed during drawing as required.

The Nb-Ti based superconducting wire 3 has a basic configuration in which the Nb-Ti alloy filaments 2 are placed in the Cu matrix 1. An alloy material used in the Nb-Ti alloy filaments 2 usually contains Nb and about 45% to 50% by mass Ti and may further contain a small amount (up to about 5% by mass) of an element such as tantalum (Ta) or hafnium (Hf) as required.

The present invention is further described below with reference to examples. The present invention is not limited to the examples. Modifications can be appropriately made within the scope described above or below and are included in the technical scope of the present invention.

### Examples

An Nb sheet (diffusion barrier layer) having a thickness of 0.1 mm and a width of 250 mm was wound around an alloy bar having an outside diameter of 54.5 mm and a length of 250 mm and containing Nb and 47% by mass Ti; the Nb sheet and the alloy bar were inserted in an oxygen-free copper pipe having an outside diameter of 70 mm, an inside diameter of 55 mm, and a length of 250 mm; and both ends of the oxygen-free copper pipe were sealed by welding, whereby an Nb-Ti single-core billet (extrusion billet) was prepared. The Nb-Ti single-core billet was extruded by a hydrostatic extrusion process so as to have a diameter of 25 mm, was drawn by drawing, and was then formed into an Nb-Ti single-core wire having a hexagonal shape in cross section (a diagonal length of 3.0 mm) using a hexagonal dice.

In an oxygen-free copper pipe having an outside diameter of 25 mm and an inside diameter of 20 mm, 31 pieces of the Nb-Ti single-core wire (hexagonal in cross section) were inserted. This oxygen-free copper pipe was subjected to reduction working, whereby an Nb-Ti multi-core wire sample having an outside diameter of 1 mm was prepared. Upon the preparation of the Nb-Ti multi-core wire sample, heat treatment was performed at 400°C for 50 hours three times during reduction working. Nb-Ti based superconducting wires prepared under various conditions (Examples 1 to 3 and Comparative Example 1 below) were measured for critical current density Jc (the critical current density non-Cu Jc of a non-copper portion) and α-phase area fraction under conditions below.

### Measurement of critical current density Jc

A sample (superconducting wire) was energized in liquid helium (a temperature of 4.2 K) under an external magnetic field of 5 T (tesla), the voltage generated therefrom was measured by a four-terminal technique, and the current (critical current Ic) used to generate an electric field of 0.1 µV/cm was measured. The current was divided by the cross-sectional area of a non-copper portion of the sample (the area of an Nb-Ti portion), whereby the critical current density non-Cu Jc (A/mm²) was determined. An acceptable standard for the critical current density non-Cu Jc is 2,600 A/mm² or more.

### Measurement of α-phase area fraction

The total area of an α-phase indicated by a black spot was determined from a reflection electron image, taken using a scanning electron microscope after final heat treatment, by image analysis software ("ImageJ" developed by the U. S. National Institutes of Health) and was divided by the area of the whole.

### Example 1

An Nb-Ti based superconducting wire was prepared by the above procedure except that a bar (an alloy bar having an outside diameter of 54.5 mm and a length of 250 mm and containing Nb and 47% by mass Ti) of a base material containing grains having an average equivalent circle diameter of 29 µm (the grain size of an Nb-Ti single-core billet) was used.

### Example 2

An Nb-Ti based superconducting wire was prepared by the above procedure except that a bar (an alloy bar having an outside diameter of 54.5 mm and a length of 250 mm and containing Nb and 47% by mass Ti) of a base material containing grains having an average equivalent circle diameter of 68 µm (the grain size of an Nb-Ti single-core billet) was used.

### Example 3

An Nb-Ti based superconducting wire was prepared by the above procedure except that a bar (an alloy bar having an outside diameter of 54.5 mm and a length of 250 mm and containing Nb and 47% by mass Ti) of a base material containing grains having an average equivalent circle diameter of 188 µm (the grain size of an Nb-Ti single-core billet) was used.

### Comparative Example 1

An Nb-Ti based superconducting wire was prepared by the above procedure except that a bar (an alloy bar having an outside diameter of 54.5 mm and a length of 250 mm and containing Nb and 47% by mass Ti) of a base material containing grains having an average equivalent circle diameter of 337 µm (the grain size of an Nb-Ti single-core billet) was used.

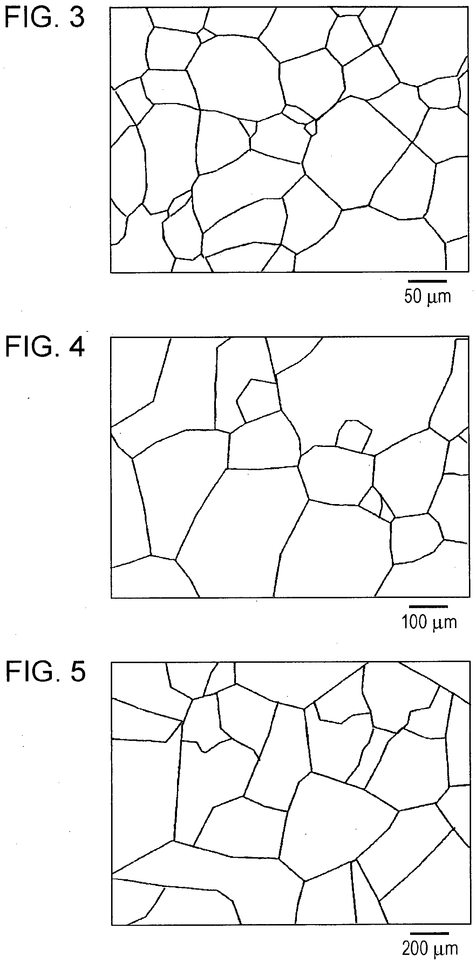

The above grain size was determined as follows: the observed area (the area of each grain) and the number of the grains were read from a drawing prepared by tracing a grain structure image obtained using an optical microscope and the average size (average equivalent circle diameter) of the grains was calculated. Fig. 2 shows a traced drawing of a grain structure image obtained in Example 1. Fig. 3 shows a traced drawing of a grain structure image obtained in Example 2. Fig. 4 shows a traced drawing of a grain structure image obtained in Example 3. Fig. 5 shows traced drawing of a grain structure image obtained in Comparative Example 1.

Table below summarizes results (α-phase area fraction and critical current density (non-Cu Jc)) of the above measurement together with the grain size of each alloy, containing Nb and 47% by mass Ti, used as a base material.

**Table**

| | Average equivalent circle diameter of base material (µm) | α-phase area fraction (%) | Critical current density non-Cu Jc of non-copper portion (A/mm²) |
|---|---|---|---|
| Example 1 | 29 | 21 | 2,952 |
| Example 2 | 68 | 20 | 2,931 |
| Example 3 | 188 | 19 | 2,850 |
| Comparative Example 1 | 337 | 15 | 2,537 |

From these results, conclusions below can be drawn. The Nb-Ti based superconducting wires prepared in Examples 1 to 3 have high critical current density because the average equivalent circle diameter of the grains in the base materials used in Examples 1 to 3 is controlled to be 200 µm or less. In contrast, the Nb-Ti based superconducting wire prepared in Comparative Example 1 has low critical current (critical current density) because the average equivalent circle diameter of the grains in the base material used in Comparative Example 1 is large. This is probably because the number of preferential precipitation sites of an α-phase is reduced during heat treatment, the α-phase area fraction after final heat treatment is small (15%), and the superconductivity of a final product is deteriorated.

## Claims

1. A process of manufacturing an Nb-Ti based superconducting wire comprising, hybridizing a stabilizer and an Nb-Ti alloy bar and then subjecting said stabilizer and Nb-Ti alloy bar to reduction working, wherein the Nb-Ti alloy bar has a grain size of 200 µm or less in terms of average equivalent circle diameter at the stage of hybridizing the Nb-Ti alloy bar with the stabilizer.

2. The process of manufacturing an Nb-Ti based superconducting wire according to Claim 1, wherein the stabilizer is copper.

3. The process of manufacturing an Nb-Ti based superconducting wire according to Claim 1 or 2, wherein the Nb-Ti alloy bar subjected to reduction working contains 16% by area or more of an α-phase in terms of proportion to the whole structure.

## Patentansprüche

1. Verfahren zur Herstellung eines auf Nb-Ti basierenden supraleitenden Drahtes, umfassend das Hybridisieren eines Stabilisators und einer Stange aus einer Nb-Ti-Legierung und danach das Unterziehen des Stabilisators und der Stange aus einer Nb-Ti-Legierung einer Verformungsbearbeitung, wobei die Stange aus einer Nb-Ti-Legierung eine Korngröße von 200 µm oder weniger in Bezug auf einen gemittelten Äquivalentkreisdurchmesser beim Hybridisieren der Stange aus einer Nb-Ti-Legierung mit dem Stabilisator aufweist.

2. Verfahren zur Herstellung eines auf Nb-Ti basierenden supraleitenden Drahtes nach Anspruch 1, wobei der Stabilisator Kupfer ist.

3. Verfahren zur Herstellung eines auf Nb-Ti basierenden supraleitenden Drahtes nach Anspruch 1 oder 2, wobei die einer Verformungsbearbeitung unterzogene Stange aus einer Nb-Ti-Legierung 16 Flächen-% oder mehr von einer α-Phase in Bezug auf einen Anteil zu der Gesamtstruktur enthält.

## Revendications

1. Procédé de fabrication d'un câble supraconducteur à base de Nb-Ti comprenant, hybrider un stabilisant et une barre en alliage de Nb-Ti et puis soumettre ledit stabilisant et barre en alliage de Ni-Tb à un écrouissage, dans lequel la barre en alliage à base de Nb-Ti a une taille de grain de 200 µm ou moins en terme de diamètre moyen de cercle équivalent à l'étape d'hybridation de la barre en alliage à base de Nb-Ti avec le stabilisant.

2. Le procédé de fabrication d'un câble supraconducteur à base de Nb-Ti selon la revendication 1, dans lequel le stabilisant est du cuivre.

3. Le procédé de fabrication d'un câble supraconducteur à base de Nb-Ti selon la revendication 1 ou 2, dans lequel le câble supraconducteur à base de Nb-Ti soumis à un écrouissage contient 16% ou plus en surface d'une phase α en terme de proportion par rapport à la totalité de la structure.
